## Europäisches Patentamt

## European Patent Office

## Office européen des brevets

(11) Publication number: **0 171 948**
**B1**

# EUROPEAN PATENT SPECIFICATION

(45) Date of publication of patent specification: **27.12.90**

(21) Application number: **85305211.6**

(22) Date of filing: **23.07.85**

(51) Int. Cl.⁵: **H 03 M 5/14,** G 11 B 20/14, H 04 L 25/49, H 03 M 5/08

(54) Method of fixed-length binary encoding and apparatus for same.

(30) Priority: **09.08.84 US 638996**

(43) Date of publication of application:
**19.02.86 Bulletin 86/08**

(45) Publication of the grant of the patent:
**27.12.90 Bulletin 90/52**

(84) Designated Contracting States:
**BE CH DE FR GB IT LI NL SE**

(56) References cited:
DE-B-1 152 277      US-A-3 633 190
US-A-3 597 752      US-A-3 882 301

IBM TECHNICAL DISCLOSURE BULLETIN, vol. 26, no. 7A, December 1983, pages 3479,3480, New York, US; I. HERNANDEZ Jr.: "Coding scheme in proportional encoding"

IEEE TRANSACTIONS ON INFORMATION THEORY, vol. IT-11, no. 2, April 1965, pages 284-292, New York, US; W.H. KAUTZ: "Fibonacci codes for synchronization control"

(73) Proprietor: **KRONOS, INC.**
**62, 4th Avenue**
**Waltham Massachusetts02154 (US)**

(72) Inventor: **Krakauer, Lawrence**
**15 Orchard Lane**
**Wayland Massachusetts (US)**
Inventor: **Baxter, Larry**
**18 Hancock Street**
**Lexington Massachusetts (US)**

(74) Representative: **Allsop, John Rowland**
**Rowland Allsop & Co. Black Boy Yard 15 High Street**
**West Wycombe High Wycombe, Bucks. HP14 3AE (GB)**

(56) References cited:
IBM TECHNICAL DISCLOSURE BULLETIN, vol. 9, no. 10, March 1967, pages 1318,1319, New York, US; M. PADALINO: "Intelligence storage (or communication) system"

IBM TECHNICAL DISCLOSURE BULLETIN; vol. 15, no. 9, February 1973, page 2809, New York, US; J LEYBOURNE: "Method for printing delta distance code"

Courier Press, Leamington Spa, England.

## Description

The present invention relates to binary data encoding and reading, being more particularly directed to the conversion of coding by a weighted code to a continuous numerical sequence, particularly useful for single track encoding and reading as on linear media and the like, such as optically readable bars or marks, time cards, magnetic strips, tapes or discs and, more generally, for data transmision purposes as well.

Recording media of the above and similar types each have a smallest resolvable unit which shall herein be termed a "cell"; the cell unit size in magnetic media being set by the maximum number of feasible flux changes per inch, or the smallest black or white bar that can be resolved in optical media. Of particular concern to the present invention are media or channels that have no separate clock signal (such as, for example, the striped or barred time cards of our prior U.S. Letters Patent Nos. 4,270,043 and 4,361,092), so that the bits recorded thereon must somehow be self-clocked.

Among the prior techniques for accomplishing this purpose is so-called Manchester-encoding, also called phase-encoding, using a transition from, say, high logic level to low logic level as a binary "1" and the converse as a "0", with the period between transitions constituting the "cell".

Each bit uses two cells, with a data transition at the end of the second cell, so there is always a "clock" transition at least every other cell. An insignificant transition is added at the end of the first cell if needed to cause the following data transition to go in the proper direction. These and related coding schemes are described, for example, in the following references: *Digital Magnetic Tape Recording for Computer Applications*, L G. Sebestyen, Chapman and Hall Ltd., London (1973), Distributed in U.S. by Halsted Press, a division of John Wiley and Sons, New York (Library of Congress Catalogue Card 73—6263); see section 5.2, "Encoding and Decoding" — general comparison of various encoding schemes; *ANSI Standard X3. 48 — 1977*, American National Standards Institute, 1430 Broadway, New York, N.Y. 10018 — ANSI standard for Manchester Phase Encoding on Full-Size Cassettes; "Digital Recording in Low-Cost Transports", Clark E. Johnson, Jr., *Digital Design*, June 1977, pp. 38—48 — general comparison of various encoding schemes; and "Pulse Codes in Serial Data Communications", Lester S. Sanders, *Computer Design*, January 1982, p. 203.

Another closely related scheme is "Frequency Modulation", in which there is a "clock" transition at the end of the first call (between data bits), with a transition at the end of of the second call constituting a "1", and no transition representing a "0". This type of technique is described in the Johnson and Sanders articles, above mentioned, and in "Simple Encoding Schemes Double Capacity of a Flexible Disc", David J. Kalstrom, *Computer Design*, September 1976, pp. 98—102 — MFM (Modified Frequency Modulation), MMFM (Modified, Modified, Frequency Modulation), and GCR (Group Coded Recording).

In the above schemes, the data density is 0.5 bits per cell, and there is always a transition (a "clock" transition used to resynchronize the reader or receiver) at least every two cells.

Another approach called "group encoding", or "run-length coding", involves groups of four bits encoded into 5-bit "run-length" codes, such as:

TABLE I

| Data | Code | Data | Code |
|------|------|------|------|
| 0000 | 11001 | 1000 | 11010 |
| 0001 | 11011 | 1001 | 01001 |
| 0010 | 10010 | 1010 | 01010 |
| 0011 | 10011 | 1011 | 01011 |
| 0100 | 11101 | 1100 | 11110 |
| 0101 | 10101 | 1101 | 01101 |
| 0110 | 10110 | 1110 | 01110 |
| 0111 | 10111 | 1111 | 01111 |

The run-lengths codes described in the Kalstrom article, above, and in "Group-Coded Recording Reliably Doubles Diskette Capacity", Pawitter S. Sidhu, *Computer Design*, December, 1976, pp. 84—88 — GCR (Group Coded Recording), are carefully chosen so that there are never more than two zeros in a row, even when two codes are concatenated. The codes are then sent using transitions for "1"s and no transitions for "0"s, as in Manchester, but without the intervening "clock" transitions. For example:

Original Data:     0 0 1 1  0 1 0 0

Run-Length Code:   1 0 0 1 1 1 1 1 1 0 1

It may be noted that up to 3 cells between transitions are possible and that this method uses only 5 cells for 4 bits, for a bit density of 0.8 bits/cell — a 60% improvement over phase or Manchester encoding. There may, however, be up to a 3-cell maximum gap in the previously described methods. In media with poor speed control, this may be critical, and sometimes cannot be tolerated.

Other methods, such as Modified Frequency Modulation (MFM or MMFM) (see the Kalstrom article, *supra*, and "Second Generation Disc Read/Write Electronics", Robert M. Batey and James D. Becker, *Hewlett Packard Journal*, January, 1984, pp. 7—12 (describes VLFM, a variant of MFM and MMFM), also increase the bit density, but similarly at the expense of longer periods without a transition to synchronize the receiver or reader.

Another coding scheme called "Variable Cell Width" (VCW) is of particular interest here, since it introduces the idea that data "1's" and data "0's" need not be the same length, (see Johnson article, *supra*, and "A Compact Tape Transport Subassembly Designed for Reliability and Low Cost", Douglas J. Collins and Brian G. Spreadbury, *Hewlett Packard Journal*, July 1980, pp. 14—19 — VCW encoding (Variable Cell Width), also called a "Delta-distance Code"). In this technique, data "1's" are longer than data "0's", so that although the average data packing density is increased (if the data have an even number of "1's" and "0's" on the average), individual record lengths will vary based on the ratio of "1's" to "0's". This is considered a major shortcoming of this technique.

Another relevant prior disclosure to which the reader is directed, is to be found in IEEE Transactions on information theory Vol IT—11, No. 2, April 1965 pages 284—292 which relates to a new family of codes with Fibonacci weights extending from 1 to the Fibonacci of n whereby n is the number of the bit position for representing a serial binary data having application to the recording or transmission of digital data without an accompanying clock. In essense this publication therefore merely uses its code to distribute synchronous information to avoid the necessity of clocking.

Underlying the present invention however is the discovery that a previously recognized mathematical oddity (the so-called Fibonacci *number — Mathematical Circus*, Martin Gardner, Alfred A. Knopf, Inc., New York (1979) ISBN 0—394—50207—8), Chapter 13, "Fibonacci and Lucas Numbers", pp. 152—168; and *The Fibonacci Quarterly*, Published by "The Fibonacci Association", University of Santa Clara, Santa Clara, California 95053, — may be developed into a weighting code for use with a raw code of variable length, converting the same into a continuous numerical sequence that, while having the noise immunity of Manchester coding and Frequency Modulation, startlingly provides substantially one-third greater bit density than such prior codes and obviates other limitations thereof. The "Fibonacci numbers" are a series in which each succeeding terms is obtained by adding the previous two terms:

n:      0 1 2 3 4 5  6  7  8  9 . . .

Fib(n): 1 1 2 3 5 8 13 21 34 55 . . .

Another object of the present invention, accordingly, is to provide a new and improved method of binary code storage or encoding that enables such greater bit density and other improvements.

A further object is to provide novel apparatus particularly suited to the utilization of such improved coding employing Fibonacci numbers.

Other and further objects will be explained hereinafter and are more particularly delineated in the appended claims.

According to one aspect of the invention there is provided a method of storing digital "1" and "0" code information comprising generating a variable length raw code with "1's" and "0's"; adjusting the "1's" to be each one cell long and the "0's" to be two cells long; using the code as a fixed length code by only using those code sequences with a fixed number of cells rather than a fixed number of bits; converting the variable length raw code into a fixed length code by weighting each "1" with a weighting sequence comprising the Fibonacci numbers of n, wherein each successive term is obtained by adding the previous two terms, n is the number of the cell position, and the weighting extends from 0 to the Fibonacci of (n-2); and adding the weighting for each "1" to convert this fixed length code to continuous numerical decimal or binary equivalent numbers.

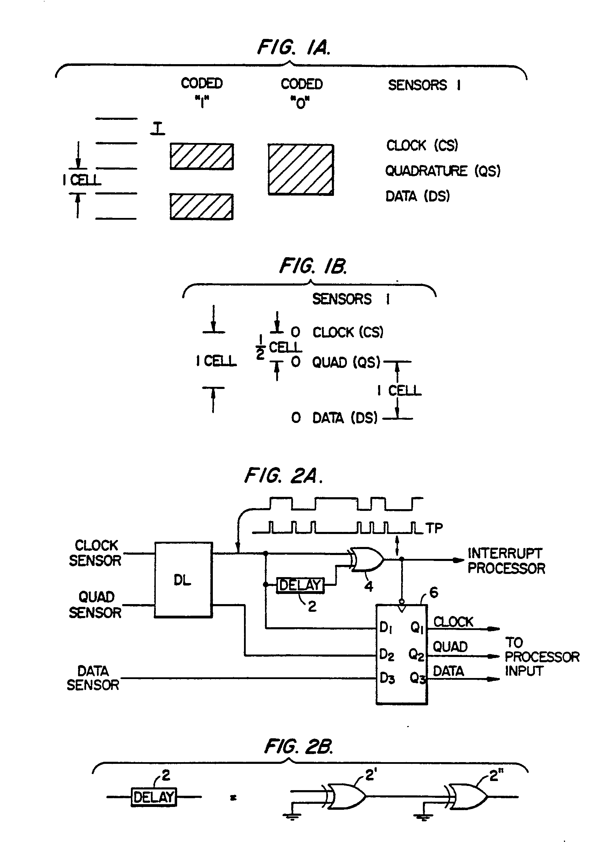

The invention will now be described in connection with the accompanying drawings, Figs. 1A and B of which are diagrammatic views of the code technique of the invention applied to optical sensing;

Figs. 2A and 2B are block circuit diagrams of a suitable reader;

Fig. 3 is a similar diagram of a logic-based debouncing circuit for use in Fig. 2A in accordance with a preferred embodiment; and

Fig. 4 is a chart illustrating the application of the variable code in the time card or similar system of Figs. 1A and 1B.

In the novel "Fibonacci Code" of the invention, a "1" is a single cell long, and a "0" is 2 cells long, with transitions separating the bits:

bits: | Ø | Ø | 1 | 1 | Ø | 1 | Ø | Ø |

cells: | | | | | | | | | | | | | | | |

The raw code is thus variable length, depending on the data. At first blush, this would seem to make the code impossible for use on magnetic media and the like where typically the physical length of a block of a fixed number of bits must be the same, regardless of what the bits are (a block on a data tape, or a "sector" on a disc). Fortuitously, however, it turns out that the weighting of the raw code data by our Fibonacci Code makes such use totally possible.

Consider the number of different codes of a given length; i.e. a given number of cells, not a given number of bits. These codes can be enumerated recursively as follows:

To generate all codes of length n cells, where n is any integer:

Rule a. Take all codes of length n-1, and add a "1" in front (since 1's are 1 cell long, this gives an n-cell code).

Rule b. Take all codes of length n-2, and add a "0" in front (since 0's are 2 cells long, this gives an n-cell code).

# EP 0 171 948 B1

## Table II

All codes of length 1 cell:        1

All codes of length 2 cells:     11
(note Os drawn 2 cells wide)    0

All codes of length 3 cells:     111
                           10
                           01

All codes of length 4 cells:     1111
                           110
                           101
                           011
                           00

All codes of length 5 cells:     11111
                           1110
                           1101
                           1011
                           100
                           0111
                           010
                           001

All codes of length 6 cells:     111111
                           11110
                           11101
                           11011
                           1100
                           10111
                           1010      (codes above line
                           1001      from rule (a);
                           01111    codes below line
                           0110      from rule (b),
                           0101      above
                           0011
                           000

Several results flow from this, as follows:

1. The number of codes of n cells in length is equal to the number of codes n-1 cells long plus the number of codes n-2 cells long. Further, there is one code of length 1 cell and two codes of length 2 cells. This is exactly the definition of the classic "Fibonacci numbers".

2. Since the numbers of codes "below the line" in Table II is always Fib (n-2), the code can be considered a weighted code (to convert to a binary equivalent); and the weight of the newly-added column on the left at level n is simply Fib(n-2).
This operation is detailed below:

Column #(n): 6 5 4 3 2 1
Column weight: 5 3 2 1 1 0 (column weight of right-most column is 0).
=Fib(n-2)

5

As an example, consider:

## TABLE III

| Codes | Decimal Equivalent |
|-------|--------------------|
| 111111 | 12 |
| 11110 | 11 |
| 111O1 | 10 |
| 11O11 | 9 |
| 11OO | 8 |
| 1O111 | 7 |
| 1O1O | 6 |
| 1OO1 | 5 |
| O1111 | 4 |
| O11O | 3 |
| O1O1 | 2 |
| OO11 | 1 |
| OOO | 0 |

Note: Add the weights of each column containing a "1" (obviously could add in binary just as easily).

Since we have developed a weighted code (essentially a variable radix code), conversion routines to and from the code are obvious. The only unusual aspect is that zeros must be expanded to "double width" before applying the weights. This conversion algorithm allows the "Fibonacci Code" to be used as a fixed-length code.

For example, blocks of 16 bits can be coded into 24 cells (Fib(24) = 75,025; $2^{16}$ = 65,536); giving a code using only 1.5 cells per bit (2/3 bit/cell = 0.666 . . . bits/cell). This code is a 33-1/3% improvement in packing density over phase encoding or Manchester encoding. Like those codes, there are at most two cells between transitions, and all transitions are exactly one cell or two cells apart.

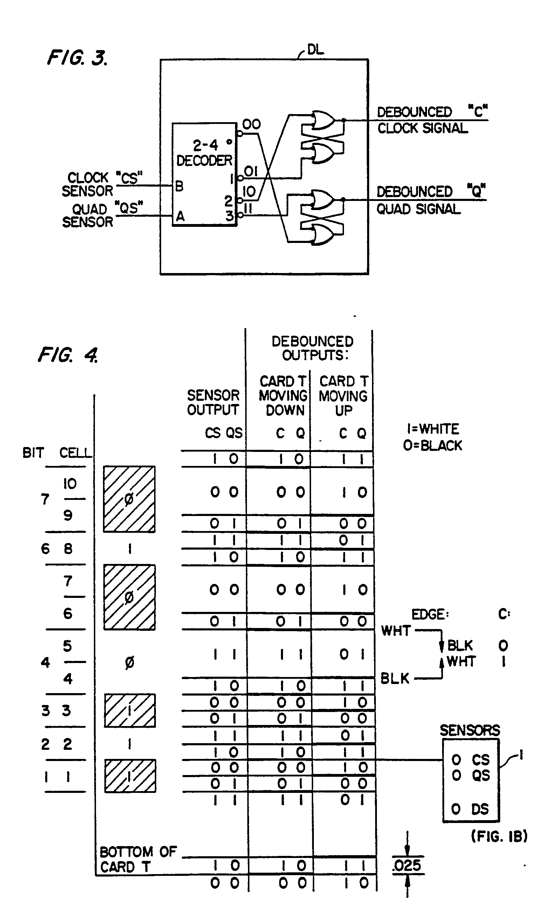

Considering an application of this technique to a moving time card, for example, containing bars distributed in accordance with the code of the invention for optical reading, a preferred scheme for reading this code optically from an irregularly moving time card, using a triple sensor, will now be described. Reference is made to Fig. 1A wherein exemplary bars for a coded "1" and coded "0" are shown on a timecard T in relation to three scanning optical sensors, labelled "clock" sensor CS (which detects the bar edge), "quadrature" sensor QS and "data" sensor DS, the spacings of which relative to a cell are more accurately portrayed in Fig. 1B. To read the code, the circuit of Figs. 2A and 2B may be employed wherein the debouncing logic circuit DL assumes the form of the circuit of Fig. 3, later described. The stage 6 of Fig. 2A may, for example, be of type 74176. Fig. 2B shows a suitable circuit form for the DELAY device 2 of Fig. 2A, the stages 2' and 2'', for example, comprising successive type 7486 stages, such stage being suitable also at 4 for generating from the DL output, bi-directionally, the transition pulses (waveform TP). The DELAY 2 sets the pulse width of the transition pulses.

The computer or processor is interrupted on each edge of the clock. At interrupt, the direction of motion can be computed from the value read in:

direction = clock ⊕ QUAD (where ⊕ is Exclusive-OR).

The data value used is

data bit = clock ⊕ data.

That is, if clock sensor output does not equal that of the data sensor, a 2-cell bar is read, which is "0". If, however, the clock and data sensor outputs are equal, 1-cell bar, is read, which is "1". This operation holds for black or white bars. A lens (not shown) can be used to image the code onto the sensors. The use of the spacially placed multiple sensors of Fig. 2A makes the reading of the code totally independent of speed or even direction of motion of the code past the sensors.

As shown in Fig. 3, the debouncing logic circuit DL is applied to the output of each of the clock and quadrature sensors. With this debouncing, at least 1/2 cell reversal of the sensors over the code (or vice-versa) must occur before there is another change in the outputs. This prevents jitter around an edge from interrupting at too rapid a rate, without introducing any delay in the response to a true valid edge. The DECODER of DL may, for example, be one-half of a type 74139, with the gates of type 7400, producing the debounced "C" and "Q" signal outputs illustrated.

The variable code application of the invention to the time card or similar useage of Figs. 1—3 is illustratively summarized in the chart of Fig. 4, showing the sensor 1 of Fig. 1B with its "CS" and "QS"

6

## EP 0 171 948 B1

outputs and the corresponding debounced outputs "C" and "Q" for the card T moving down and up, respectively. The debounced "C'" output is used to produce interrupts and is defined as the state after interrupt, as diagrammatically shown to the right in Fig. 4.

### Claims

1. A method of storing digital "1" and "0" code information comprising generating a variable length raw code with "1's" and "0's"; adjusting the "1's" to be each one cell long and the "0's" to be two cells long; using the code as a fixed length code by only using those code sequences with a fixed number of cells rather than a fixed number of bits; converting the variable length raw code into a fixed length code by weighting each "1" with a weighting sequence comprising the Fibonacci number of n, wherein each successive term is obtained by adding the previous two terms, n is the number of the cell position, and the weighting extends from 0 to the Fibonacci of (n-2); and adding the weighting for each "1" to convert this fixed length code to continuous numerical decimal or binary equivalent numbers.

2. A method as claimed in claim 1 and in which the last-named numbers are encoded and read on recording media.

3. A method as claimed in claim 1 and in which the last-named numbers are used for encoded data transmission.

4. A data encoding apparatus comprising means for generating a variable length raw code with "1's" to be each one cell long and "0's" to be two cells long; means for using the code as a fixed length code by only using those code sequences with a fixed number of cells rather than a fixed number of bits; means for converting said variable length raw cell into a fixed length code by weighting each "1" with a weighting sequence comprising the Fibonacci numbers of n, wherein each successive term is obtained by adding the previous two terms, n is the number of the cell position, and the weighting extends from 0 to the Fibonacci of (n-2); and means for adding the weighting for each "1" to convert this fixed length code to continuous numerical decimal or binary equivalent numbers.

5. Apparatus as claimed in claim 4 and in which means is provided for utilizing said continuous numerical sequence for track encoding and reading optically readable cards and surfaces and magnetic strips, tapes and discs, and for data transmission.

### Patentansprüche

1. Verfahren zum Speichern einer digitalen Code-Information mit "1en" und "0en", dadurch gekennzeichnet, daß ein Roh-Code variabler Länge mit "1en" und "0en" hergestellt wird, daß die "1en" so eingestellt werden, daß jede die Länge einer Zelle hat, und die "0en" so eingestellt werden, daß jede die Länge von zwei Zellen hat, daß der Code als Code fester Länge verwendet wird, indem nur die Codefolgen mit einer festen Zahl von Zellen anstatt einer festen Anzahl von Bits verwendet werden, daß der Roh-Code mit variabler Länge in einen Code mit fester Länge dadurch umgewandelt wird, daß jede "1" mit einer Bewertungsfolge bewertet wird, die die Fibonacci-Zahlen von n aufweisen, wobei jeder aufeinander folgende Ausdruck durch Addieren der vorausgehenden beiden Ausdrücke erzielt wird, n die Anzahl der Zellenposition ist, und die Bewertung sich von 0 bis zu der Fibonacci-Zahl von (n-2) erstreckt, und daß die Bewertung für jede "1" hinzugefügt wird, um zur Umwandlung diesen Code fester Länge in kontinuierliche numerische dezimal- oder binäräquivalente Zahlen umzuwandeln.

2. Verfahren nach Anspruch 1, dadurch gekennzeichnet, daß die zuletzt erwähnten Zahlen kodiert und in ein Aufzeichnungsmedium eingelesen werden.

3. Verfahren nach Anspruch 1, dadurch gekennzeichnet, daß die zuletzt erwähnten Zahlen für eine kodierte Datenübertragung verwendet werden.

4. Datenkodiereinrichtung mit einer Vorrichtung zur Erzeugung eines Roh-Codes veranderbarer Länge mit "1en" mit einer Länge von einer Zelle und "0en" mit einer Länge von zwei Zellen, einer Vorrichtung zur Verwendung des Codes als Code fester Länge, indem nur die Codefolgen mit einer festen Anzahl von Zellen anstelle einer festen Anzahl von Bits verwendet werden, einer Vorrichtung zer Umwandlung der Rohzelle variabler Länge in einen Code fester Länge durch Bewertung jeder "1" mit einer Bewertungsfolge, die die Fibonacce-Zahlen von n enthalt, wobei jeder aufeinander folgende Ausdruck durch Addieren der vorausgehenden beiden Ausdrucke erzielt wird, n die Zahl der Zellenposition ist und die Bewertung sich von 0 bis zu der Fibonaccei-Zahl von (n-2) erstreckt, und einer Vorrichtung zum Addieren der Bewertung fur jede "1", um diesen Code fester Länge in kontinuierliche numerische dezimal- oder binaraquivalente Zahlen umzuwandeln.

5. Einrichtung nach Anspruch 4, dadurch gekennzeichnet, daß eine Vorrichtng zur Verwendung der kontinuierlichen numerischen Folge fur die Spurkodierung und für das optische Auslesen von lesbaren Karten und Oberflachen und Magnetstreifen, Bändern und Disks sowie fur die Datenubertragung vorgesehen ist.

### Revendications

1. Méthode pour l'enregistrement des données numériques codées avec des "1" et des "0". A cette fin, cette méthode doit engendrer un code brut de longueur variable avec des "1" et des "0"; ajuster la longueur des "1" pour qu'elle corresponde à une cellule et cell des "0" pour qu'elle corresponde à deux cellules; utiliser le code comme un code de longueur fixe en n'utilisant que des séquences caractérisées par un nombre fixe de cellules au lieu d'un nombre fixe de bits; convertir le code brut de longueur variable en un code de longueur fixe en pondérant chaque "1" avec une séquence de pondération utilisant les nombres de Fibonacci de n, qui veut que chaque terme suivant est obtenu en additionnant les deux termes précédents, n correspondant au numéro de position de la cellule, et la pondération allant de 0 au Fibonacci de (n-2); et, enfin, ajouter la pondération à chaque "1" pour convertir ce code de longueur fixe en nombrés décimaux numériques continus ou nombres binaires équivalents.

2. Une méthode qui fait l'objet de la revendication 1 et dans laquelle ces derniers nombres cités sont codés et lus au moyen de supports d'enregistrement.

3. Une méthode qui fait l'objet de la revendication 1 et dans laquelle ces derniers nombres cités sont utilisés pour transmettre des données codées.

4. Un appareil de codage des données qui permet de produire un code brut de longueur variable avec des "1" de une cellule de longueur et des "0" de deux cellules de longeur; permet d'utiliser le code comme un code de longueur fixe en n'utilisant que des séquences de code caractérisées par un nombre fixe de cellules au lieu d'un nombre fixe de bits; permet de convertir le code brut de longueur variable en un code de longueur fixe en pondérant chaque "1" avec une séquence de pondération utilisant les nombres de Fibonacci de n, qui veut que chaque terme suivant est obtenu en additionnant les deux termes précédents, n correspondant au numéro de position de la cellule, et la pondération allant de 0 au Fibonacci de (n-2); et, permet d'ajouter la pondération à chaque "1" pour convertir ce code de longueur fixe en nombres décimaux numériques continus ou nombres binaires équivalents.

5. L'appareil qui fait l'objet de la revendication 4 et qui permet d'utiliser la séquence numérique continue mentionnée pour l'enregistrement et la lecture de piste sur des cartes et surfaces à lecture optique ainsi que sur les feuillets, bandes et disques magnétiques, et pour la transmission de données.

## FIG. 1A.

CODED "I"  CODED "O"  SENSORS I

I

CLOCK (CS)

I CELL  QUADRATURE (QS)

DATA (DS)

## FIG. 1B.

SENSORS I

½ CELL  O  CLOCK (CS)

I CELL  O  QUAD (QS)

I CELL

O  DATA (DS)

## FIG. 2A.

TP

CLOCK
SENSOR

DL

DELAY
2

4

INTERRUPT
PROCESSOR

QUAD
SENSOR

6

D₁  Q₁  CLOCK

D₂  Q₂  QUAD

TO
PROCESSOR
INPUT

DATA
SENSOR

D₃  Q₃  DATA

## FIG. 2B.

2

DELAY  ≡  2'  2"

1

FIG. 3.

2-4 DECODER

CLOCK "CS" SENSOR → B

QUAD "QS" SENSOR → A

OO 0
OI 1
IO 2
II 3

DL

DEBOUNCED "C" CLOCK SIGNAL

DEBOUNCED "Q" QUAD SIGNAL

FIG. 4.

|  |  | SENSOR OUTPUT | DEBOUNCED OUTPUTS: | |
|---|---|---|---|---|
|  |  |  | CARD T MOVING DOWN | CARD T MOVING UP |
| BIT | CELL |  | | |
|  |  | CS QS | C Q | C Q |
|  |  | I O | I O | I I |
| 7 | 10 / 9 | 0 0 | 0 0 | I O |
|  |  | O I | O I | O O |
| 6 | 8 | I I | I I | O I |
|  |  | I O | I O | I I |
|  | 7 / 6 | 0 0 | 0 0 | I O |
|  |  | O I | O I | O O |
| 4 | 5 / 4 | I I | I I | O I |
|  |  | I O | I O | I I |
| 3 | 3 | 0 0 | 0 0 | I O |
|  |  | O I | O I | O O |
| 2 | 2 | I I | I I | O I |
|  |  | I O | I O | I I |
|  |  | 0 0 | 0 0 | I O |
| I | I | O I | O I | O O |
|  |  | I I | I I | O I |
| BOTTOM OF CARD T |  | I O | I O | I I |
|  |  | 0 0 | 0 0 | I O |

I = WHITE
O = BLACK

EDGE:        C:

WHT ── ↓BLK   O
      ↑WHT   I
BLK ──

SENSORS

O CS
O QS
O DS

(FIG. IB)

.025

2